# EUROPEAN PATENT APPLICATION

(11) **EP 3 244 158 A1**
(43) Date of publication of application: **15.11.2017**
(21) Application number: 17170221.0
(22) Date of filing: 09.05.2017
(51) Int. Cl.: F28F 3/12, F28F 3/02, F28D 9/00, F28F 13/08, F25B 39/04, H05K 7/20

(54) **CONSTANT VAPOR VELOCITY CONDENSER**

(30) Priority: 09.05.2016 US 201615149878
(71) Applicant: Hamilton Sundstrand Corporation, Windsor Locks, CT 06096-1010 (US)
(72) Inventor: CAMPBELL, Kris H., Poplar Grove, IL 61065 (US); BOURAS, Scott R., Crystal Lake, Illinois (US)
(74) Representative: Hughes, Andrea Michelle

(57) **Abstract**

A condensing heat exchanger to exchange heat from a hot flow to a cold flow includes a hot flow side (110) to receive the hot flow (103), the hot flow side including a hot flow inlet (102) disposed on a hot flow inlet side (112) and a hot flow outlet (104) disposed on a hot flow outlet side (118), wherein a hot flow side cross section decreases from the hot flow inlet side to the hot flow outlet side, a cold flow side to receive the cold flow, and an interface (111) disposed between the hot flow side and the cold flow side to allow thermal communication therebetween.

## Description

### BACKGROUND

The subject matter disclosed herein relates to vapor cycle cooling systems, and more particularly, to vapor cycle cooling systems for aircraft electronics.

Aircraft electronics utilized within an aircraft may utilize large amounts of power in compact packages. Condensing heat exchangers are used in a variety of aerospace utilizing Rankine loops, HVAC, two-phase thermal management loops and electronics cooling. Often, aircraft electronics may require heat exchangers with higher heat transfer coefficients, better non-condensable control, inventory stability and tolerance to orientation and g-field (including micro-gravity).

### BRIEF SUMMARY

According to an embodiment, a condensing heat exchanger to exchange heat from a hot flow to a cold flow includes a hot flow side to receive the hot flow, the hot flow side including a hot flow inlet disposed on a hot flow inlet side and a hot flow outlet disposed on a hot flow outlet side, wherein a hot flow side cross section decreases from the hot flow inlet side to the hot flow outlet side, a cold flow side to receive the cold flow, and an interface disposed between the hot flow side and the cold flow side to allow thermal communication therebetween.

Technical function of the embodiments described above includes that a hot flow side cross section decreases from the hot flow inlet side to the hot flow outlet side.

Other aspects, features, and techniques of the embodiments will become more apparent from the following description taken in conjunction with the drawings.

### BRIEF DESCRIPTION OF THE DRAWINGS

The subject matter is particularly pointed out and distinctly claimed in the claims at the conclusion of the specification. The foregoing and other features, and advantages of the embodiments are apparent from the following detailed description taken in conjunction with the accompanying drawings in which like elements are numbered alike in the FIGURES:

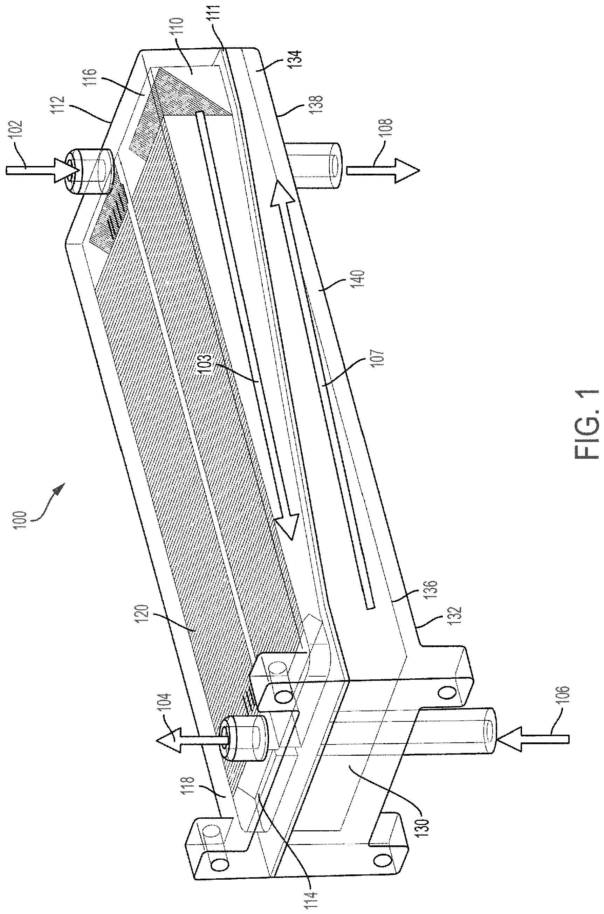

FIG. 1 is a perspective view of one embodiment of a condensing heat exchanger.

### DETAILED DESCRIPTION

Referring to FIG. 1, a condensing heat exchanger 100 is shown. In the illustrated embodiment, the condensing heat exchanger 100 includes a hot side 110 and a cold side 130 in thermal communication via an interface 111. In the illustrated embodiment, the hot side 110 can receive hot flow 103 from a component cooling loop. The heat exchanger 100 can be utilized to cool components such as power systems and other suitable components in an aircraft and in other applications. In the illustrated embodiment, the cold side 130 can receive cold flow 107 to remove heat from the hot flow 103. In the illustrated embodiment, the condensing heat exchanger 100 is a counter flow liquid cooled shear flow heat exchanger. In certain embodiments, the condensing heat exchanger 100 is a cross flow shear flow heat exchanger or a parallel flow heat exchanger. Advantageously, the condensing heat exchanger 100 is a compact unit that can be a line replaceable unit. In the illustrated embodiment, the condensing heat exchanger 100 includes a tapering flow area to maintain a constant vapor velocity to improve overall heat transfer for greater efficiency and a more compact design.

In the illustrated embodiment, the hot side 110 can receive hot flow 103. The hot side 110 of the condensing heat exchanger 100 includes an inlet side 112, a hot flow inlet 102, an outlet side 118, a hot flow outlet 104, and fins 120. The hot flow inlet 102 receives the hot flow 103. The hot flow 103 may be received by the hot flow inlet 102 as a superheated vapor. The hot flow 103 may be carrying heat removed from electrical components or any other suitable component. In other embodiments, the hot flow 103 may be received as a two phase flow or a liquid flow. The hot flow 103 may be formed from any suitable fluid.

In the illustrated embodiment, the hot flow 103 can travel through the hot side 110 from the inlet side 112 to the outlet side 118. As the hot flow 103 travels through the hot side 110, the hot flow 103 is directed through fins 120 to facilitate heat transfer with the cold side 130 with a maximized exposed surface area.

In the illustrated embodiment, the fins 120 are tapered to decrease in height along the flow direction of the hot flow 103. As the fins 120 taper, the cross sectional area of the hot side 110 decreases as the hot flow 103 moves from the inlet side fins 116 to the outlet side fins 114. In certain embodiments, the tapered geometry of the fins 120 can be formed using additive manufacturing techniques. Further, in certain embodiments, the condensing heat exchanger 100 is entirely formed using additive manufacturing techniques. In other embodiments, the tapered geometry of the fins 120 can be formed using vacuum brazing or any other suitable manufacturing techniques.

In the illustrated embodiment, the fins 120 are a generally trapezoidal shape. In other embodiments, the fins 120 can be any suitable geometry wherein the fins 120 taper to decrease a cross sectional area as the hot flow 103 flows from the inlet side fins 116 to the outlet side fins 114. During operation, as heat is transferred from the hot flow 103 to the cold flow 107, the hot flow 103 can condense. In the illustrated embodiment, as the hot flow 103 moves from the inlet side fins 116 to the outlet side fins 114 the hot flow 103 may start as superheated vapor, condense to two phase fluid, and then be cooled to a subcooled liquid phase. The fins 120 facilitate phase changes within the hot side 110.

In the illustrated embodiment, the tapered design of the fins 120 allows for vapor velocity of a mixed phase hot flow 103 to be maintained, particularly as the hot flow condenses into greater amounts of liquid flow. Advantageously, by allowing for constant vapor velocity, heat transfer performance of the condensing heat exchanger 100 is enhanced.

In particular, vapor velocity is a primary factor in determining condensate film thickness and thereby heat transfer coefficient of the hot flow 103 within the fins 120. As the flow area of the fins 120 decreases along the hot flow 103 path higher heat transfer coefficients in the low quality flow region can be obtained. Because the low quality region has the lowest heat transfer coefficient values, the overall heat transfer coefficient is improved. Further, since vapor velocity is maintained, the influence of non-condensable components within the hot flow 103 are mitigated, since non-condensables are forced to the end of the condensation and do not blanket a large upstream area.

After the hot flow 103 has travelled through the fins 120, the cooled hot flow 103, which may now be a subcooled liquid, can return to the remainder of the cooling loop via the hot flow outlet 104.

In the illustrated embodiment, the cold side 130 can receive cold flow 107. The cold side 130 of the condensing heat exchanger 100 includes an inlet side 132, a cold flow inlet 106, an outlet side 134, a cold flow outlet 108, and fins 140. The cold flow inlet 106 receives the cold flow 107. The cold flow 107 may be received by the cold flow inlet 106 as a cooled liquid. The cold flow 107 can be any suitable liquid or fluid to remove heat from the condensing heat exchanger 100.

In the illustrated embodiment, the cold flow 107 can travel through the cold side 130 from the inlet side 132 to the outlet side 134. As the cold flow 107 travels through the cold side 130, the cold flow 107 is directed through fins 140 to facilitate heat transfer with the hot side 110 with a maximized exposed surface area.

In the illustrated embodiment, the fins 140 may be tapered to decrease in height along the flow direction of the cold flow 107. The fins 140 may be tapered to reduce overall height of the condensing heat exchanger 100. In certain embodiments, the fins 140 may be tapered similar to fins 120 to maintain vapor velocity if a two phase fluid flow within the cold flow 107 is desired. In certain embodiments, the tapered geometry of the fins 140 can be formed using additive manufacturing techniques. In other embodiments, the tapered geometry of the fins 140 can be formed using vacuum brazing or any other suitable manufacturing techniques.

In the illustrated embodiment, the fins 140 are a generally trapezoidal shape. In other embodiments, the fins 140 can be any suitable geometry wherein the fins 140 taper to decrease a cross sectional area as the cold flow 107 flows from the inlet side 132 to the outlet side 134.

After the cold flow 107 has travelled through the fins 140, the cold flow 107 can return to the remainder of the cooling loop via the cold flow outlet 108.

In the illustrated embodiment, the condensing heat exchanger 100 has an interface 111 between the hot side 110 and the cold side 130 to facilitate heat transfer therebetween. The interface 111 can be any suitable surface that allows the transfer of heat between the fins 120 and the fins 140 to allow heat to be removed from the hot flow 103 to the cold flow 107. In the illustrated embodiment, the shear flow configuration of the condensing heat exchanger 100 allows for greater heat transfer in a compact design. Further, shear flow heat exchangers allow for greater tolerance to orientation and adverse g-field environments, including micro-gravity. Additionally, the condensing heat exchanger 100 can provide a positive condensing pressure drop to provide greater flow stability.

The terminology used herein is for the purpose of describing particular embodiments only and is not intended to be limiting of the embodiments. While the description of the present embodiments has been presented for purposes of illustration and description, it is not intended to be exhaustive or limited to the embodiments in the form disclosed. Many modifications, variations, alterations, substitutions or equivalent arrangement not hereto described will be apparent to those of ordinary skill in the art without departing from the scope of the invention as defined by the claims. Additionally, while various embodiments have been described, it is to be understood that aspects may include only some of the described embodiments. Accordingly, the embodiments are not to be seen as limited by the foregoing description, but are only limited by the scope of the appended claims.

## Claims

1. A condensing heat exchanger to exchange heat from a hot flow to a cold flow, the condensing heat exchanger comprising:
a hot flow side (110) to receive the hot flow (103), the hot flow side including a hot flow inlet (102) disposed on a hot flow inlet side (112) and a hot flow outlet (104) disposed on a hot flow outlet side (118), wherein a hot flow side cross section decreases from the hot flow inlet side to the hot flow outlet side;
a cold flow side (130) to receive the cold flow (107); and
an interface (111) disposed between the hot flow side and the cold flow side to allow thermal communication therebetween.

2. The condensing heat exchanger of claim 1, the cold flow side including a cold flow inlet (106) disposed on a cold flow inlet side (132) and a cold flow outlet (108) disposed on a cold flow outlet side (134).

3. The condensing heat exchanger of claim 2, wherein a cold flow side cross section decreases from the cold flow inlet side to the cold flow outlet side.

4. The condensing heat exchanger of any preceding claim, wherein the hot flow side includes a plurality of hot flow fins (120).

5. The condensing heat exchanger of claim 4, wherein a cross section of each of the plurality of hot flow fins decreases from the hot flow inlet side to the hot flow outlet side.

6. The condensing heat exchanger of claim 1, wherein the cold flow side includes a plurality of cold flow fins (140).

7. The condensing heat exchanger of claim 6, wherein a cross section of each of the plurality of cold flow fins decreases from the cold flow inlet side to the cold flow outlet side.

8. The condensing heat exchanger of any preceding claim, wherein the hot flow side provides counter-flow to the cold flow side.

9. The condensing heat exchanger of any of claims 1 to 7, wherein the hot flow side provides cross-flow to the cold flow side.

10. The condensing heat exchanger of any preceding claim, wherein the hot flow side provides a constant vapor velocity within the hot flow.

11. The condensing heat exchanger of any preceding claim, wherein the condensing heat exchanger is a line replaceable unit.

12. The condensing heat exchanger of any preceding claim, wherein the condensing heat exchanger is made via additive manufacturing.

13. The condensing heat exchanger of any of claims 1 to 11, wherein the condensing heat exchanger is made by vacuum brazing.
